Europäisches Patentamt

(19) European Patent Office  (11) Numéro de publication: **0 167 440**

Office européen des brevets  **B1**

(12) **FASCICULE DE BREVET EUROPÉEN**

(45) Date de publication du fascicule du brevet:  (51) Int. Cl.⁴: **H 01 L 29/747**, H 01 L 29/10
03.02.88

(21) Numéro de dépôt: **85401223.4**

(22) Date de dépôt: **19.06.85**

(54) Triac de protection sans gachette, réalisé à partir d'un substrat à haute résistivité.

(30) Priorité: **29.06.84 FR 8410348**

(43) Date de publication de la demande:
**08.01.86 Bulletin 86/2**

(45) Mention de la délivrance du brevet:
**03.02.88 Bulletin 88/5**

(84) Etats contractants désignés:
**DE FR GB IT NL SE**

(56) Documents cité:
**EP-A-0 080 044**
**EP-A-0 110 777**
**US-A-3 896 477**
**US-A-4 275 408**

(73) Titulaire: **THOMSON SEMICONDUCTEURS, 101,
bld Murat, F-75016 - Paris (FR)**

(72) Inventeur: **Noguier, Jean- Pierre, THOMSON- CSF
SCPI- 173, bld Haussmann, F-75379 Paris Cedex 08
(FR)**
Inventeur: **Montaut, Jean- Paul, THOMSON- CSF
SCPI- 173, bld Haussmann, F-75379 Paris Cedex 08
(FR)**

(74) Mandataire: **Guérin, Michel, THOMSON- CSF SCPI
19, avenue de Messine, F-75008 Paris (FR)**

## Description

La présente invention concerne un composant semiconducteur monolithique bidirectionnel destiné à la protection rapide de circuits contre des surtensions. On appellera dans la suite ce composant "triac de protection" bien que cette appellation ne soit pas absolument adéquate puisqu'un triac comporte normalement une électrode de gâchette tandis que le composant dont il s'agit n'en comporte pas. L'invention est également applicable pour un composant unidirectionnel, s'est-à-dire un thyristor unique sans gâchette.

Ce triac de protection sans gâchette est normalement bloqué et devient conducteur lorsqu'il s'amorce sous l'effet d'une surtension positive ou négative entre ses électrodes principales. Il est en principe placé entre les bornes d'entré ou d'alimentation d'un circuit lorsque les lignes d'entrée ou d'alimentation sont susceptibles de recevoir des surtensions transitoires élevées qui pourraient endommager ce circuit.

Un triac de protection connu comprend, sur une même pastille semiconductrice, deux thyristors (sans gâchette) adjacents NPNP et PNPN tête-bêche, la région N centrale étant commune aux deux thyristors, les surfaces avant et arrière des pastilles étant uniformément métallisées pour former une première électrode (anode d'un thyristor et cathode de l'autre) et une deuxième électrode (cathode du premier thyristor et anode de l'autre). Le pourtour de la pastille est en principe délimité par un sillon périphérique qui coupe la jonction entre la région centrale de type N et la région de type P adjacente à cette région N du côté de la face considérée. Le sillon n'est pas recouvert de métal mais d'une couche de passivation (verre).

Le triac se déclenche, en cas de surtension, par une mise en avalanche d'une partie de la jonction entre la région N centrale et l'une ou l'autre des régions P adjacentes, selon le sens de la tension; le courant d'avalanche dans la région P entraine une polarisation latérale de la jonction NP, créant une injection de charges capable d'amorcer localement l'un des thyristors lorsque cette polarisation atteint une valeur de 0,6 à 0,7 volt. La zone d'amorçage, initialement localisée du côté du point de déclenchement de l'avalanche, s'etend progressivement à tout le triac.

Dans ce type de triac à déclenchement par avalanche, dit aussi triac à retournement, l'avalanche initiale se produit non pas dans le volume du triac mais essentiellement à la périphérie de la jonction PN dans le sillon passivé, parce que la tension de claquage superficielle de cette jonction est plus faible que la tension de claquage en volume, ceci notamment à cause du fait que le sillon crée du côté de la région P un angle aigu (biseau) défavorable à la tenue en tension. Il peut en résulter des problèmes de non-uniformité d'amorçage dans le volume du triac, donc de densités de puissance excessives en certains endroits, pouvant endommager prematurement le dispositif.

Par ailleurs, la tension de claquage superficielle de la jonction PN, qui dépend essentiellement de la concentration en impuretés de la région centrale de type N, n'est pas prévisible de manière certaine a cause du sillonnage périphérique, et de plus n'est pas absolument uniforme sur toute la périphérie de la pastille. Par conséquent, on a là non seulement une cause supplémentaire de non uniformité d'amorçage (non uniformité le long de la périphérie), mais aussi une cause d'incertitude sur la valeur de surtension à partir de laquelle le triac s'amorce et joue son rôle de protection. On souhaiterait bien entendu pouvoir définir précisément et surtout prévoir, lors de la fabrication, la valeur nominale d'amorçage du triac: 100 volts, 150 volts, 200 volts etc...

Un autre inconvénient du dispositif de protection connu est le fait que le principe de déclenchement par avalanche exige que le courant initial d'avalanche crée dans la région de type P adjacente à la région centrale de type N une certaine chute de potentiel résistive qui favorisera l'injection de charges déclenchant l'un des thyristors. La concentration dans la région P est donc imposée par cette contrainte, ce qui implique nécessairement que le choix d'une tension de claquage déterminée, pour aboutir à une valeur nominale de fonctionnement du triac, se fasse pratiquement exclusivement par un choix de la concentration de type N dans la région centrale. Or, cette région est constituée par le substrat de départ de type N et, pour réaliser une gamme de triacs de valeurs nominales variées, il faut donc partir d'une gamme de substrats de concentrations variées, ce qui augmente le coût de fabrication.

L'invention cherche à éliminer ces inconvénients et propose à cet effet une nouvelle structure de triac de protection à retournement.

Ce triac est constitué classiquement par une pastille semiconductrice incorporant deux thyristors tête-bêche juxtaposés, chaque thyristor comportant une région d'anode de type P, une région centrale de type N, une région dite de gâchette de type P et une region de cathode de type N, les régions centrales de type N des deux thyristors étant constituées par une même couche de substrat de type N, une métallisation recouvrant sur chaque face de la pastille la région d'anode et la région de cathode affleurant sur cette face, et des trous de court-circuit étant prévus, par lesquels la région de gâchette de type P remonte à travers la région de cathode de type N jusqu'à la métallisation qui la recouvre. La région centrale possède une faible concentration de type N, telle que la tension de claquage superficielle inverse à l'affleurement de la jonction entre la région centrale et la région de gâchette soit nettement plus élevée que la tension de déclenchement du triac, et il est prévu pour chaque thyristor au moins une zone spécifique de type N, plus dopée que la région centrale, séparant la région centrale de la région de gâchette, cette région étant localisée en regard d'une partie de la région de gâchette du thyristor correspondant mais ne s'étendant pas jusqu'à la périphérie de la pastille.

On expliquera mieux les avantages de cette structure dans la description détaillée qui suit et qui est faite en référence aux dessins annexés dans lesquels:

- la figure 1 représente en coupe verticale un triac de protection classique;
- la figure 2 représente ce triac en vue de dessus;
- la figure 3 représente en coupe verticale un premier mode de réalisation du dispositif de protection selon l'invention;
- la figure 4 représente en vue de dessus le dispositif de la figure 3;
- Les figures 5 et 6 représentent en vue de dessus deux autres modes de réalisation;
- la figure 7 représente, en coupe transversale, un quatrième mode de réalisaton.

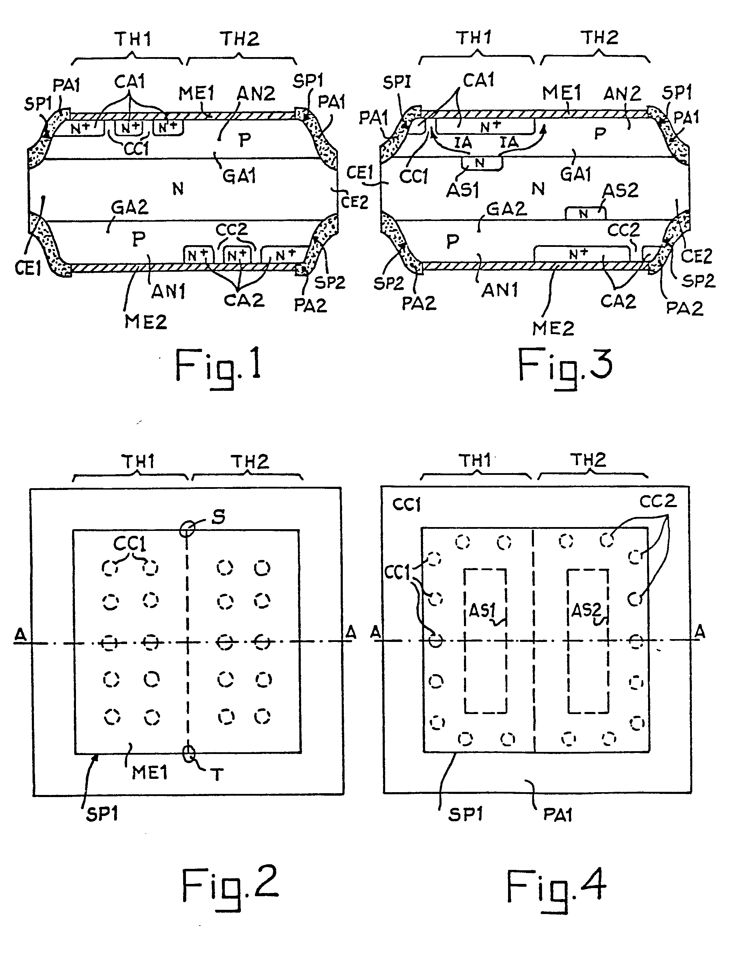

Sur la figure 1 (coupe transversale selon la ligne A-A de la figure 2) et sur la figure 2 (vue de dessus), on voit un triac de protection classique formé dans une pastille semiconductrice.

Sans reprendre la description déjà faite d'un tel triac, on précise ici qu'on a désigné le premier thyristor par TH1 (partie gauche des figures) et le deuxième par TH2 (partie droite); les régions d'anodes de type P de TH1 et TH2 par AN1 et AN2; les régions centrales de type N par CE1 et CE2 mais ces régions sont constituées par une couche commune qui est le substrat de départ de la pastille; les régions dites de gâchette interne de type P par GA1 et GA2; les régions de cathode de type N par CA1 et CA2; les métallisations par ME1 pour l'une des faces et ME2 pour l'autre; le sillon périphérique entourant la pastille par SP1 sur la première face et par SP2 pour la deuxième face, et enfin les couches de passivation recouvrant ces sillons par PA1(sillon SP1) et PA2 (sillon SP2).

Le fonctionnement de principe de ce dispositif est le suivant: le triac est normalement non conducteur; en cas de surtension entre les métallisations ME1 et ME2 qui sont reliées aux bornes extérieures du triac, cette surtension se reporte essentiellement aux bornes de la jonction PN entre couche centrale et région de gâchette de l'un ou l'autre des deux thyristors, selon le sens de la surtension.

Dans la suite de la description, on considèrera que la métallisation ME2 est portée à un potentiel plus élevé que la métallisation ME1. Le raisonnement serait tout à fait symétrique dans le cas contraire.

La jonction entre la région d'anode AN1 ou la région de gâchette GA2 et la région centrale CE1, CE2 est polarisée en direct et la surtension se reporte donc aux bornes de la jonction (polarisée en inverse) entre la région centrale CE1 et la région de gâchette GA1 du thyristor TH1, de même d'ailleurs qu'entre la région centrale CE2 (qui est constituée par la même couche de type N que CE1) et la région d'anode AN2 (qui est constituée par la même couche de type P que GA1) du thyristor TH2.

Lorsque la surtension dépasse une certaine valeur, cette jonction NP polarisé en inverse se met en régime d'avalanche; ce phénomène n'est toutefois pas uniforme sur toute la surface de la jonction; au contraire le claquage par avalanche se produit essentiellement là où le champ électrique est renforcé, c'est-à-dire là où la jonction rencontre le sillon périphérique SP1. Cette propriété spécifique est due tant au profil du sillon qu'à la nature du diélectrique utilisé pour passiver la jonction.

Le courant périphérique qui en résulte tend à se diriger de la zone d'avalanche vers l'électrode ME1, là où elle est en contact avec la couche AN2 de type P.

Ce courant circule dans une région résistive de type P et il en résulte, au-dessous de la région de cathode CA1 du thyristor TH1, une chute de potentiel latérale qui est suffisante pour engendrer l'injection d'électrons de la cathode dans la gâchette, et par suite un déclenchement du thyristor TH1.

Des trous de court-circuit CC1 (thyristor TH1) et CC2 (TH2) sont prévus pour contribuer à l'évacuation du courant d'avalanche vers la métallisation ME1: ces trous sont des remontées de la région de gâchette GA1 (CA2) à travers les régions de cathode CA1 (CA2) jusqu'à la métallisation ME1 (ME2).

Le courant d'avalanche peut donc jouer le rôle d'un courant de gâchette interne dans ce dispositif sans électrode de gâchette. Lorsque la surtension a disparu, le triac se bloque à nouveau dès le moment où il cesse d'être parcouru par un courant suffisant, c'est-à-dire lorsque le courant descend au-dessous du courant dit de maintien.

Malheureusement, dans cette structure, le phénomène d'avalanche se produit sur toute la périphérie de la jonction CE1, GA1, et notamment au voisinage de la ligne de séparation entre les thyristors TH1 et TH2, c'est-à-dire au voisinage des points S et T de la figure 2. Or, en ces points, le courant d'avalanche rejoint directement la métallisation ME1, sans passer sous la cathode CA1 du thyristor TH1, donc en générant dans ce voisinage une différence de potentiel latérale inhomogène vis-à-vis du reste de la périphérie du dispositif et par la suite peu favorable à l'amorçage périphérique uniforme du dispositif.

Le thyristor TH1 s'amorce donc de manière non uniforme et il y a alors risque d'endommagement ou de destruction du triac du fait de cet amorçage non uniforme.

La tension à laquelle le triac s'amorce n'est pas définie avec autant de certitude qu'on le voudrait; elle dépend essentiellement de la concentration de type N du substrat de départ (couche CE1, CE2) une fois que la concentration de type P des régions de gâchette GA1 et GA2 a été fixée pour faire en sorte que le courant d'avalanche initial produise une chute de tension latérale déterminée dans son trajet sous la cathode.

La présente invention propose une structure conforme aux figures 3 et 4 qui sont à rapprocher des figures 1 et 2 et qui portent les mêmes références pour les mêmes éléments.

Dans cette structure nouvelle, la différence par rapport à la structure des figures 1 et 2 est de deux ordres:

- d'une part la concentration de la couche centrale CE1, CE2, c'est-à-dire du substrat de départ, est beaucoup plus faible; et surtout cette concentration n'est pas lié directement à la tension nominale de déclenchement du triac. Elle est seulement suffisamment faible pour que la tension de claquage superficiel de la jonction entre les régions CE1 et GA1 ou CE2 et GA2 à la périphérie de cette jonction soit nettement plus forte que la tension de déclenchement du triac. Par exemple, la concentration correspond à une résistivité d'environ 50 ohms cm (concentration d'environ $1 \times 10^{14}$ atomes/cm$^3$) et à une tension de claquage superficielle de 1000 volts ou plus, alors que la tension de déclechement du triac peut être de 50 volts, 100 volts, 150 volts, 300 volts, 500 volts par exemple.

- d'autre part, il est prévu une région supplémentaire de type N, AS1 pour le thyristor TH2, AS2 pour le thyristor TH2, cette région étant plus dopée que la couche centrale CE1, CE2, et étant adjacente à la région de gâchette GA1 (ou GA2) sur une portion de celle-ci, de manière à créer avec cette portion de gâchette une jonction qui est localisée à l'intérieur de la pastille et qui ne s'étend pas jusqu'à proximité de la périphérie de la pastille. Le dopage de cette région est ajusté de manière que la tension de claquage en volume de cette jonction AS1, GA1 (ou AS2, GA2) corresponde à la tension de déclenchement désiré pour le thyristor correspondant (on peut imaginer que la tension ne soit pas la même dans les deux sens de polarité si on dope différemment les régions AS1 et AS2). La profondeur des régions AS1, AS2 est faible par rapport à l'épaisseur de la couche centrale CE1, CE2.

Dans le mode de réalisation des figures 3 et 4, la région AS1 est constituée par une zone unique située sensiblement au milieu du thyristor TH1. Elle n'est pas située en regard des trous de courtcircuit CC1 mais dans l'intervalle entre une rangée de trous et la limite des thyristors TH1 et TH2 (l'anode du thyristor TH2 à la limite entre les deux thyristors joue le même rôle que les trous de court-circuit par lesquels les courants circulant dans la région de gâchette GA1 peuvent rejoindre la métallisation ME1). Les trous de court-circuit CC1 sont de préférence prévus à proximité immédiate et même adjacents à la périphérie de la pastille (plus exactement du bord du sillon périphérique passivés lorsqu'un tel sillon est prévu). Les trous de court-circuit sont bien entendu recouverts par la métallisation ME1. Lorsque la tension aux bornes du triac augmente (tension positive du côté de la métallisation ME2 par rapport à la métallisation ME1), le claquage en volume se produit à la jonction entre les régions AS1 et CA1. Le courant d'avalanche 1A qui en résulte (flèches sur la figure 3) se dirige latéralement à travers la région de gâchette interne GA1 vers les trous de court-circuit CC1 pour atteindre l'électrode ME1 qui est au potentiel le plus négatif. La chute de tension latérale engendre à l'endroit de la jonction GA1, CA1 une différence de potentiel suffisante pour assurer à travers cette jonction une injection de charges qui déclenche la conduction du thyristor TH1. La disposition de la région AS2 par rapport au thyristor TH2 dans les modes de réalisation décrits est symétrique de celle de la région AS1 par rapport au thyristor TH1.

On voit sur la figure 4 que les régions AS1 et AS2 ne s'étendent pas jusqu'à la périphérie de la pastille, ceci pour qu'il n'y ait pas d'affleurement superficiel des jonctions AS1/GA1 ou AS2/GA2, notamment dans le sillon périphérique, et donc qu'il n'y ait pas de risque de claquage superficiel de ces jonctions; en effet, un tel claquage superficiel introduirait les mêmes problèmes de non-uniformité d'amorçage et d'imprécision de la tension de déclenchement que ceux que l'on rencontre dans la structure des figures 1 et 2.

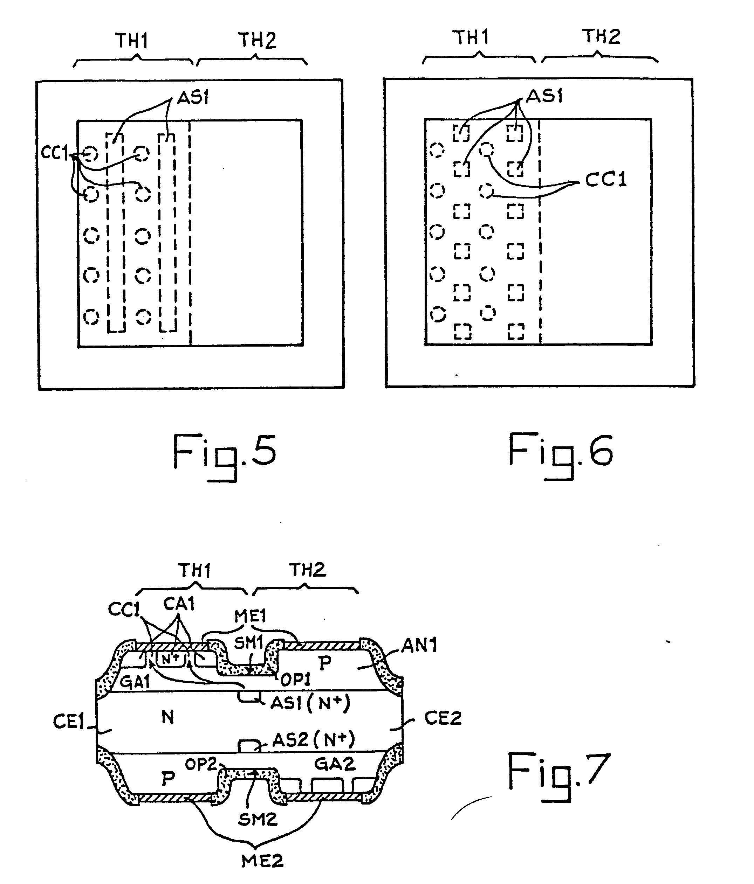

Dans un autre mode de réalisation, représenté seulement en vue de dessus à la figure 5, on a prévu que la région AS1 de type N est constituée de deux zones localisées, réparties de manière à ne pas se trouver en regard des trous de court-circuit CC1 mais plutôt entre deux rangées de trous de court-circuit ainsi qu'entre une rangé de trous et la limite entre les deux thyristors TH1 et TH2. Seuls les trous CC1 et la région AS1 relatifs au thyristor TH1 sont représentés sur la figure 5.

Dans un troisième mode de réalisation, représenté seulement en vue de dessus à la figure 6, on a prévu, en vue d'améliorer l'uniformité de l'amorçage dans tout le thyristor, que la région AS1 est constituée par une pluralité de zones très localisées, réparties de manière a se situer entre les trous de court-circuits CC1 ou entre ces trous et la limite des thyristors TH1 et T2.

Pour faciliter la compréhension, les trous de court-circuit sont représentés ronds et les zones AS1 carrées, mais il est évident qu'on peut choisir les formes comme on le désire, notamment de manière à optimiser la répartition des lignes de courant d'avalanche; comme à la figure 5, les régions AS2 ne sont pas représentées.

Dans un quatrième mode de réalisation, visible en coupe latérale à la figure 7, les régions AS1 et AS2 sont situées en regard l'une de l'autre à la limite entre les thyristors TH1 et TH2; là encore ces régions ne vont pas jusqu'à la périphérie de la pastille ou du sillon; d'autre part, les métallisations ME1 et ME2 peuvent être interrompues en regard des régions AS1 et AS2 par la présence d'une couche d'oxyde de passivation (OP1, OP2) et éventuellement même d'un sillon médian passivé (SM1 et SM2) creusé sur une partie de la profondeur des régions de gâchette GA1 et GA2 et des régions d'anode CA1 et CA2. On crée ainsi l'équivalent d'une résistance supplémentaire de ballastage limitant le courant d'avalanche initial et améliorant l'uniformité de la répartition des lignes de ce courant au moment du déclenchement.

Le procédé de fabrication de ces structures ne pose pas de problème particulier. Il néccssite une diffusion de type N supplémentaire de chaque côté de la pastille, avec un masque de délimitation des régions AS1 et AS2.

Ce procédé consiste pour l'essentiel à:
- partir d'un substrat de type N de résistivité élevée (40 à 60 ohms. cm par exemple),
- effectuer une diffusion profonde, localisée aux régions AS1 et AS2, de type N sur les deux faces du substrat; la profondeur de diffusion est légèrement supérieure à l'épaisseur des futures régions d'anode AN1, AN2. La concentration est choisie en fonction de la tension de déclenchement desiree,
- effectuer une diffusion de type P+ non localisée, sur les deux faces du substrat, pour réaliser les régions d'anode et de gâchette;
- effectuer une diffusion N+ de cathode, localisée, sur les deux faces du substrat. Le masque de diffusion sur la face superieure protège à la fois l'anode AN2 du thyristor TH2 et les court-circuits CC1 du thyristor TH1;
- graver un sillon périphérique autour des pastilles individuelles qui seront découpées dans le substrat de départ;
- recouvrir d'une couche de verre les faces du substrat et graver cette couche pour la laisser subsister dans les sillons et dans les régions OP1 et OP2;
- métalliser les deux faces du substrat par trempage;
- découper le substrat en pastilles individuelles et les monter en boîtier à deux électrodes.

Toute la description qui précède a été faite à propos d'un composant bidirectionnel (triac) comportant deux thyristors tête-bêche. Cependant, l'invention est applicable exactement de la même manière pour un composant unidirectionnel, c'est-à-dire un thyristor unique sans gâchette. Dans ce cas évidemment la zone spécifique de type N (AS1) ne sera pas située à la limite d'un thyristor comme à la figure 7, mais essentiellement au centre de la pastille donc au centre du thyristor unique.

## Revendications

1. Triac de protection à retournement, sans gâchette, constitué par une pastille semiconductrice incorporant deux thyristors tête-bêche juxtaposés (TH1, TH2), chaque thyristor comportant une région d'anode de type P (AN1, AN2), une région centrale de type N (CE1, CE2), une région dite de gâchette de type P (GA1, GA2), et une région de cathode de type N (CA1, CA2), les régions centrales de type N des deux thyristors étant constituées par une même couche de substrat de type N, une métallisation (ME1, ME2) recouvrant sur chaque face de la pastille la région d'anode et la région de cathode affleurant sur cette face, et des trous de courtcircuit (CC1, CC2) étant prévus, par lesquels la région de gâchette de type P remonte à travers la région de cathode de type N jusqu'à la métallisation qui la recouvre, caractérisé en ce que la région tension de claquage superficielle inverse à l'affleurement de la jonction entre la région centrale et la région de gâchette soit nettement plus élevée que la tension de déclenchement du triac, et en ce qu'il est prévu pour chaque thyristor (TH1, TH2) au moins une zone spécifique de type N (AS1, AS2), plus dopée que la région centrale, séparant la région centrale de la région de gâchette, cette région étant localisée en regard d'une partie de la région de gâchette du thyristor correspondant mais ne s'étendant pas jusqu'à la périphérie de la pastille.

2. Triac de protection à retournement selon la revendication 1, caractérisé en ce que la zone spécifique de type N (AS1, AS2) ne s'étend pas en regard des trous de court-circuit du thyristor correspondant mais entre ces trous de court-circuit ou entre ces trous et la limite entre les deux thyristors tête-bêche.

3. Triac de protection à retournement selon la revendication 2, caractérisé en ce que la zone spécifique est divisée en plusieurs zones réparties de manière à ne pas être à l'aplomb des trous de circuit.

4. Triac de protection à retournement selon la revendication 1, caractérisé en ce que les zones spécifiques (AS1, AS2) s'étendent le long de la limite des deux thyristors.

5. Triac de protection à retournement selon la revendication 4, caractérisé en ce que la superficie de la pastille semiconductrice est passivée et non métallisée à l'aplomb des zones spécifiques (AS1, AS2).

6. Thyristor de protection a retournement, sans gâchette, constitué par une pastille semiconductrice et comportant une région d'anode de type P (AN1), une région centrale de type N (CE1), une région dite de gâchette de type P (GA1), et une région de cathode de type N (CA1), une métallisation (ME1, ME2) recouvrant sur une face de la pastille la région de cathode et sur l'autre face la région d'anode, et des trous de court-circuit (CC1) étant prévus, par lesquels la région de gâchette de type P remonte à travers la région de cathode de type N jusqu'à la métallisation (ME1) qui la recouvre caractérisé en ce que la région centrale posséde une faible concentration de type N, telle que la tension de claquage superficielle inverse à l'affleurement de la jonction entre la région centrale et la région de gâchette soit nettement plus élevée que la tension de déclenchement du thyristor, et en ce qu'il est prévu au moins une zone spécifique de type N (AS1), plus dopée que la région centrale, séparant la région centrale de la region de gâchette, cette region étant localisée en regard d'une partie de la région de gâchette du thyristor mais ne s'étendant pas jusqu'à la périphérie de la pastille.

**Patentansprüche**

1. Zündelektrodenloser Schutztriac mit Lawineneffektzündung, der von einem Halbleiterplättchen gebildet ist, das zwei antiparallel geschaltete Thyristoren (TH1, TS2) enthält, von denen jeder eine Anodenzone (AN1, AN2) vom Typ P, eine Mittelzone (CE1, CE2) vom Typ N, eine Zündzone (GA1, GA2) vom Typ P sowie eine Kathodenzone (CA1, CA2) zum Typ N enthält, wobei die Mittelzonen vom Typ N der zwei Thyristoren von der gleichen Substratschicht vom Typ N gebildet sind, mit einer jede Fläche des Plättchens bedeckenden Metallisierung (ME1, ME2), wobei die Anodenzone und die Kathodenzone an dieser Fläche liegen, und mit Kurzschlußlöchern (CC1, CC2), durch die die Zündzone vom Typ P durch die Kathodenzone vom Typ N hindurch bis zu der diese bedeckenden Metallisierung reicht, dadurch gekennzeichnet, daß die Mittelzone eine schwache Konzentration vom Typ N aufweist, so daß die inverse Oberflächen-Durchbruchspannung auf Höhe des Übergangs zwischen der Mittelzone und der Zündzone höher als die Zündspannung des Triac ist und daß für jeden Thyristor (TH1, TH2) wenigstens eine besondere Zone (AS1, AS2) vom Typ N vorhanden ist, die stärker als die Mittelzone dotiert ist und die Mittelzone von der Zündzone trennt, wobei diese Zone in Ausrichtung auf einen Teil der Zündzone des entsprechenden Thyristors angeordnet ist, sich jedoch nicht bis zum Umfang des Halbleiterplättchens erstreckt.

2. Schutztriac nach Anspruch 1, dadurch gekennzeichnet, daß sich die besondere Zone (AS1, AS2) vom Typ N nicht in Gegenüberlage zu den Kurzschlußlöchern des entsprechenden Thyristors, sondern zwischen diesen Kurzschlußlöchern oder zwischen diesen Löchern und der Grenze zwischen den zwei antiparellel geschalteten Thyristoren erstreckt.

3. Schutztriac nach Anspruch 2, dadurch gekennzeichnet, daß die besondere Zone in mehrere Teilzonen unterteilt ist, die so verteilt sind, daß sie nicht senkrecht unter den Kurzschlußlöchern liegen.

4. Schutztriac nach Anspruch 1, dadurch gekennzeichnet, daß die besonderen Zonen (AS1, AS2) sich längs der Grenze der beiden Thyristoren erstrecken.

5. Schutztriac nach Anspruch 4, dadurch gekennzeichnet, daß die Oberfläche des Halbleiterplättchens in senkrechter Richtung zu den besonderen Zonen (AS1, AS2) passiviert und nicht metallisiert ist.

6. Zündelektrodenloser Schutzthyristor mit Lawineneffektzündung, der von einem Salbleiterplättchen gebildet ist, mit einer Anodenzone (AN1) vom Typ P, einer Mittelzone (CE1) vom Typ N, einer Zündzone (GA1) vom Typ P und einer Kathodenzone (CA1) vom Typ N, einer Metallisierung (ME1, ME2), die auf einer Fläche des Halbleiterplättchens die Kathodenzone und auf der anderen Fläche die Anodenzone bedeckt, und Kurzschlußlöchern (CC1), durch die die Zündzone vom Typ P durch die Kathodenzone vom Typ N hindurch bis zu der Metallisierung (ME1) reicht, die die Kathodenzone bedeckt, dadurch gekennzeichnet, daß die Mittelzone eine schwache Konzentration vom Typ N aufweist, so daß die inverse Oberflächen-Durchbruchspannung auf Höhe des Übergangs zwischen der Mittelzone und der Zündzone höher als die Zündspannung des Thyristors ist, und daß wenigstens eine besondere Zone (AS1) vom Typ N vorgesehen ist, die stärker als die Mittelzone dotiert ist und die Mittelzone von der Zündzone trennt, wobei diese Zone in Gegenüberlage zu einem Teil der Zündzone des Thyristors angeordnet ist, sich jedoch nicht bis zum Umfang des Halbleiterplättchens erstreckt.

**Claims**

1. Trigger-electrode protection triac with avalanche firing constituted by a semiconductor wafer incorporating two antiparallel-connected thyristors (TH1, TH2), each tthyristor having an anode zone (AN1, AN2) of type P, a central zone (CE1, CE2) of type N, a trigger zone (GA1, GA2) of type P and a cathode zone (CA1, CA2) of type N, the central zones of type N of the two thyristors being formed by the same substrate layer of type N, a metallization (ME1, ME2) covering each face of the wafer, the anode zone and the cathode zone lying at said face, and short-circuiting holes (CC1, CC2) through which the trigger zone of type P extends through the cathode zone of type N up to the metallization covering the latter, characterized in that the central region comprises a weak concentration of type N so that the superficial inverse breakdown voltage at the level of the junction between the central zone and the trigger zone is higher than the trigger voltage of the triac and that for each thyristor (TS1, TS2) at least one specific zone (AS1, AS2) of type N is provided which is doped more than the central zone and separates the central zone from the trigger zone, said zone being arranged in alignment with a portion of the trigger zone of the corresponding thyristor but not extending through to the periphery of the semiconductor wafer.

2. Protection triac according to claim 1, characterized in that the specific zone (AS1, AS2) of type N does not extend opposite the short-circuit holes of the corresponding thyristor but between said short-circuit holes or between said holes and the border between the two antiparallel-connected thyristors.

3. Protection triac according to claim 2, characterized in that the specific zone is subdivided into a plurality of sub-zones distributed in such a manner that they do not lie vertically beneath the short-circuit holes.

4. Protection triac according to claim 1, characterized in that the specific zones (AS1, AS2) extend along the border of the two thyristors.

5. Protection triac according to claim 4, characterized in that the surface of the semiconductor wafer is passivated and not metallized in perpendicular direction to the specific zones (AS1, AS2).

8. Trigger-electrodeless protection thyristor with avalanche triggering constituted by a semiconductor wafer, comprising an anode zone (AN1) of type P, a central zone (CE1) of type N, a trigger zone (GA1) of type P and a cathode zone (CA1) of type N, a metallization (ME1, ME2) covering on one face of the semiconductor wafer the cathode zone and on the other face the anode zone, and short-circuit holes (CC1) through which the trigger zone of type P extends through the cathode zone of type N up to the metallization (ME1) covering the cathode zone, characterized in that the central zone has a weak concentration of type N so that the superficial inwerse breakdown voltage at the level of the junction between the central zone and the trigger zone is higher than the trigger voltage of the thyristor and at least one specific zone (AS1) of type N is provided which is doped more than the central zone and separates the central zone from the trigger zone, said zone being disposed opposite a portion of the trigger zone of the thyristor but not extending up to the periphery of the semiconductor wafer.

Fig.1

Fig.3

Fig.2

Fig.4

Fig.5

Fig.6

Fig.7